# EUROPEAN PATENT APPLICATION

(11) **EP 4 675 674 A2**
(43) Date of publication of application: **07.01.2026**
(21) Application number: 25185306.5
(22) Date of filing: 25.06.2025
(51) Int. Cl.: H01L 21/677, H01L 21/687

(54) **COOLING SYSTEM, SUBSTRATE PROCESSING APPARATUS, SUBSTRATE PROCESSING METHOD, METHOD OF MANUFACTURING SEMICONDUCTOR DEVICE AND PROGRAM**

(30) Priority: 28.06.2024 JP 2024105419
(71) Applicant: Kokusai Electric Corp., Tokyo 1010045 (JP)
(72) Inventor: TAKAHASHI, Akira, Toyama-shi, 939-2393 (JP); HIYAMA, Shin, Toyama-shi, 939-2393 (JP)
(74) Representative: Verscht, Thomas Kurt Albert

(57) **Abstract**

It is possible to improve a cooling efficiency of a substrate. There is provided a technique that includes: a vessel provided with a support capable of supporting a plurality of substrates in a multistage manner; and a plurality of cooling nozzles arranged along an inner surface of the vessel, wherein each of the plurality of cooling nozzles is provided with a gas supply hole through which a cooling gas is supplied for the plurality of substrates supported by the support, wherein a first cooling nozzle and a second cooling nozzle among the plurality of cooling nozzles are configured such that the cooling gas is supplied for a first substrate among the plurality of substrates through the gas supply hole of the first cooling nozzle, and the cooling gas is supplied for a second substrate other than the first substrate among the plurality of substrates through the gas supply hole of the second cooling nozzle.

## Description

### [Technical Field]

The present disclosure relates to a cooling system, a substrate processing apparatus, a substrate processing method, a method of manufacturing a semiconductor device and a program.

### [Related Art]

As a part of a manufacturing process of a semiconductor device, a process of supplying an inert gas to a plurality of substrates in a load lock chamber may be performed. For example, the load lock chamber is provided between an atmospheric transfer space and a substrate accommodating space (also referred to as a "substrate holding space") and configured such that the plurality of substrates are in standby in the load lock chamber.

### [Related Art Document]

### [Patent Document]

Patent Document 1: Japanese Patent Laid-Open No. 2012-99711

### [Disclosure]

### [Technical Problem]

For example, a process of cooling the plurality of substrates may be preformed while the plurality of substrates are in standby in the load lock chamber described above.

According to the present disclosure, there is provided a technique capable of improving a cooling efficiency of a substrate.

### [Technical Solution]

According to an embodiment of the present disclosure, there is provided a technique that includes: a vessel provided with a support capable of supporting a plurality of substrates in a multistage manner; and a plurality of cooling nozzles arranged along an inner surface of the vessel, wherein each of the plurality of cooling nozzles is provided with a gas supply hole through which a cooling gas is supplied for the plurality of substrates supported by the support, wherein a first cooling nozzle and a second cooling nozzle among the plurality of cooling nozzles are configured such that the cooling gas is supplied for a first substrate among the plurality of substrates through the gas supply hole of the first cooling nozzle, and the cooling gas is supplied for a second substrate other than the first substrate among the plurality of substrates through the gas supply hole of the second cooling nozzle.

### [Advantageous Effects]

As described above, according to some embodiments of the present disclosure, it is possible to improve the cooling efficiency of the substrate.

### [Brief Description of Drawings]

FIG. 1 is a diagram schematically illustrating a configuration of a substrate processing apparatus according to one or more embodiments of the present disclosure.
FIG. 2 is a diagram schematically illustrating a vertical cross-section of the substrate processing apparatus according to the embodiments of the present disclosure.
FIG. 3 is a diagram schematically illustrating a vertical cross-section of a load lock chamber of the substrate processing apparatus according to the embodiments of the present disclosure.
FIG. 4 is a diagram schematically illustrating a horizontal cross-section of the load lock chamber of the substrate processing apparatus according to the embodiments of the present disclosure.
FIG. 5 is a block diagram schematically illustrating a configuration of a controller and its related components of the substrate processing apparatus according to the embodiments of the present disclosure.
FIG. 6 is a flow chart schematically illustrating a flow of a cooling process in the load lock chamber of the substrate processing apparatus according to the embodiments of the present disclosure.

### [Detailed Description]

### <Embodiments of Present Disclosure>

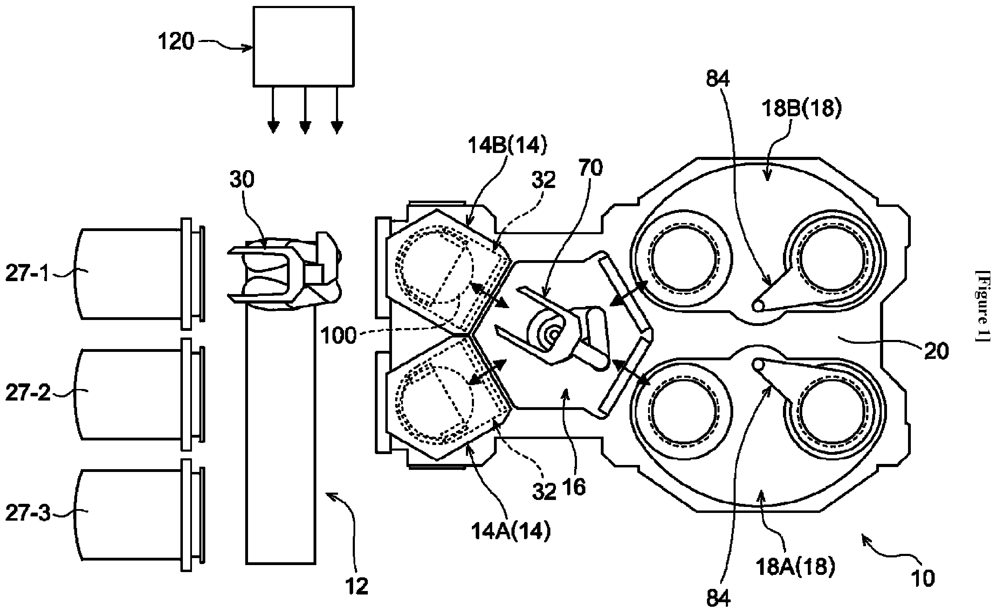

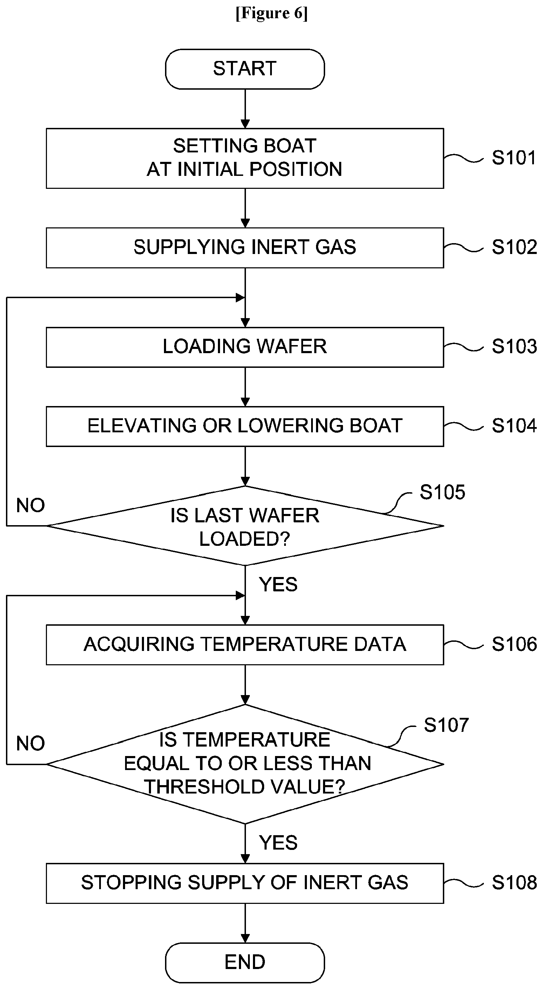

Hereinafter, one or more embodiments (also simply referred to as "embodiments") according to the technique of the present disclosure will be described mainly with reference to FIGS. 1 to 6. The drawings used in the following descriptions are all schematic. For example, a relationship between dimensions of each component and a ratio of each component shown in the drawing may not always match the actual ones. Further, even between the drawings, the relationship between the dimensions of each component and the ratio of each component may not always match. In addition, the same or similar reference numerals represent the same or similar components in the drawings. Thus, each component is described with reference to the drawing in which it first appears, and redundant descriptions related thereto will be omitted unless particularly necessary. In addition, the technique of the present disclosure is not limited to the embodiments described below. That is, the technique of the present disclosure may be appropriately modified in various ways without departing from the scope thereof.

### (1) Configuration of Substrate Processing Apparatus

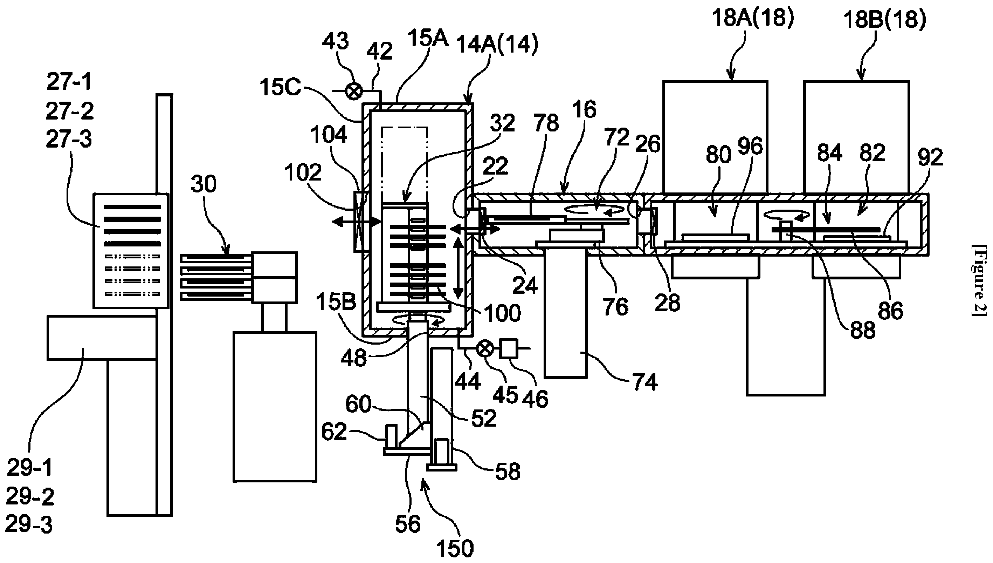

As shown in FIGS. 1 and 2, a substrate processing apparatus 10 according to the present embodiments may include: an atmospheric transfer chamber (EFEM: Equipment Front End Module) 12; loading port structures 29-1, 29-2 and 29-3 connected to the atmospheric transfer chamber 12 and serving as mounting structures (placing structures) on which pods 27-1, 27-2 and 27-3 serving as substrate storage containers are placed; load lock chambers 14A and 14B serving as pressure-controlled preliminary chambers; a transfer chamber 16 serving as a vacuum transfer chamber; and process chambers 18A and 18B in which a plurality of wafers 100 serving as substrates are processed. Hereinafter, each of the plurality of wafers 100 may also be referred to as a "wafer 100". Further, a partition wall (which is a boundary wall) 20 is provided so as to separate the process chamber 18A and the process chamber 18B.

According to the present embodiments, configurations of the load lock chambers 14A and 14B (including configurations associated with the load lock chambers 14A and 14B) are substantially the same. Therefore, the load lock chambers 14A and 14B may also be collectively or individually referred to as a "load lock chamber 14".

Further, according to the present embodiments, configurations of the process chambers 18A and 18B (including configurations associated with the process chambers 18A and 18B) are substantially the same. Therefore, the process chambers 18A and 18B may also be collectively or individually referred to as a "process chamber 18".

As shown in FIG. 2, a communication structure 22 is provided between the load lock chamber 14 and the transfer chamber 16 so as to communicate between adjacent chambers (that is, the load lock chamber 14 and the transfer chamber 16). The communication structure 22 is configured to be opened or closed by a gate valve 24.

As shown in FIG. 2, a communication structure 26 is provided between the transfer chamber 16 and the process chamber 18 so as to communicate between adjacent chambers (that is, the transfer chamber 16 and the process chamber 18). The communication structure 26 is configured to be opened or closed by a gate valve 28.

An atmospheric robot 30 serving as an atmospheric transfer structure is provided in the atmospheric transfer chamber 12. The atmospheric robot 30 is configured to transfer the wafer 100 between the load lock chamber 14 and each of the pods 27-1 to 27-3 placed on the loading port structures 29-1 to 29-3, respectively. The atmospheric robot 30 is configured to be capable of simultaneously transferring two or more wafers among the wafers 100 in the atmosphere.

The load lock chamber 14 is configured such that the wafer 100 is transferred (loaded) into or transferred (unloaded) out of the load lock chamber 14. The load lock chamber 14 is configured such that a pressure (inner pressure) thereof can be switched between an atmospheric pressure and a vacuum pressure. That is, when the wafer 100 is transferred (that is, loaded or unloaded) between the load lock chamber 14 and the atmospheric transfer chamber 12, the inner pressure of the load lock chamber 14 is switched to the atmospheric pressure, and when the wafer 100 is transferred (that is, loaded or unloaded) between the load lock chamber 14 and the transfer chamber 16, the inner pressure of the load lock chamber 14 is switched to the vacuum pressure. In addition, the load lock chamber 14 is configured such that the wafers 100 (which are unprocessed) are loaded into the load lock chamber 14 by the atmospheric robot 30. Hereinafter, the wafers 100 which are unprocessed may also be simply referred to as "unprocessed wafers 100", and each of the unprocessed wafers 100 may also be referred to as an "unprocessed wafer 100". The unprocessed wafers 100 loaded into the load lock chamber 14 are then unloaded out of the load lock chamber 14 by a vacuum robot 70 described later. On the other hand, the load lock chamber 14 is configured such that the wafers 100 (which are processed) are loaded into the load lock chamber 14 by the vacuum robot 70. Hereinafter, the wafers 100 which are processed may also be simply referred to as "processed wafers 100", and each of the processed wafers 100 may also be referred to as a "processed wafer 100". The processed wafers 100 loaded into the load lock chamber 14 are then unloaded out of the load lock chamber 14 by the atmospheric robot 30. The load lock chamber 14 will be described in detail later.

The vacuum robot 70 serving as a vacuum transfer structure is provided in the transfer chamber 16. The vacuum robot 70 is configured to transfer the wafer 100 between the load lock chamber 14 and the process chamber 18. The vacuum robot 70 may include: a substrate transfer structure 72 capable of supporting and transferring the wafer 100; and a transfer driver (which is a transfer driving structure) 74 capable of rotating the substrate transfer structure 72 and elevating or lowering the substrate transfer structure 72.

An arm structure 76 is provided in the substrate transfer structure 72. The arm structure 76 is provided with a finger 78 on which the wafer 100 is placed. Alternatively, a plurality of fingers including the finger 78 may be provided on the arm structure 76 at a predetermined interval therebetween in an up-down direction (vertical direction). For example, a plurality of arm structures including the arm structure 76 may be provided in a multistage manner. In addition, the finger 78 is configured to be extendable and retractable substantially in a horizontal direction.

The wafer 100 can be moved from the load lock chamber 14 to the process chamber 18 by moving the wafer 100 supported by a boat 32 into the transfer chamber 16 by the vacuum robot 70 via the communication structure 22 and further moving the wafer 100 into the process chamber 18 by the vacuum robot 70 via the communication structure 26.

Further, the wafer 100 can be moved from the process chamber 18 to the load lock chamber 14 by moving the wafer 100 in the process chamber 18 into the transfer chamber 16 by the vacuum robot 70 via the communication structure 26 and then supporting the wafer 100 on the boat 32 by the vacuum robot 70 via the communication structure 22.

A first process structure 80, a second process structure 82 and a substrate mover (which is a substrate moving structure) 84 are provided in the process chamber 18. The second process structure 82 is located farther from the transfer chamber 16 than the first process structure 80, and the substrate mover 84 is configured to transfer the wafer 100 between the second process structure 82 and the vacuum robot 70.

The first process structure 80 may include a first mounting table 96 on which the wafer 100 can be placed and a first heater (not shown) configured to heat the first mounting table 96.

The second process structure 82 may include a second mounting table 92 on which the wafer 100 can be placed and a second heater (not shown) configured to heat the second mounting table 92.

The first process structure 80 and the second process structure 82 are configured to process the wafer 100 in the same manner.

For example, the substrate mover 84 is constituted by: a mover (which is a moving structure) 86 capable of supporting the wafer 100; and a moving shaft 88 provided in the vicinity of the partition wall 20. The mover 86 is provided so as to be rotatable around the moving shaft 88 serving as a rotation axis. Further, the mover 86 can be elevated and lowered around the moving shaft 88.

For example, by rotating the mover 86 toward the first process structure 80, the substrate mover 84 is capable of transferring the wafer 100 to or from the vacuum robot 70 at the first process structure 80. Thereby, the substrate mover 84 is capable of moving the wafer 100 transferred by the vacuum robot 70 to the second mounting table 92 of the second process structure 82 and also capable of moving the wafer 100 placed on the second mounting table 92 to the vacuum robot 70.

Subsequently, the load lock chamber 14 will be described in detail mainly with reference to FIGS. 2 to 4.

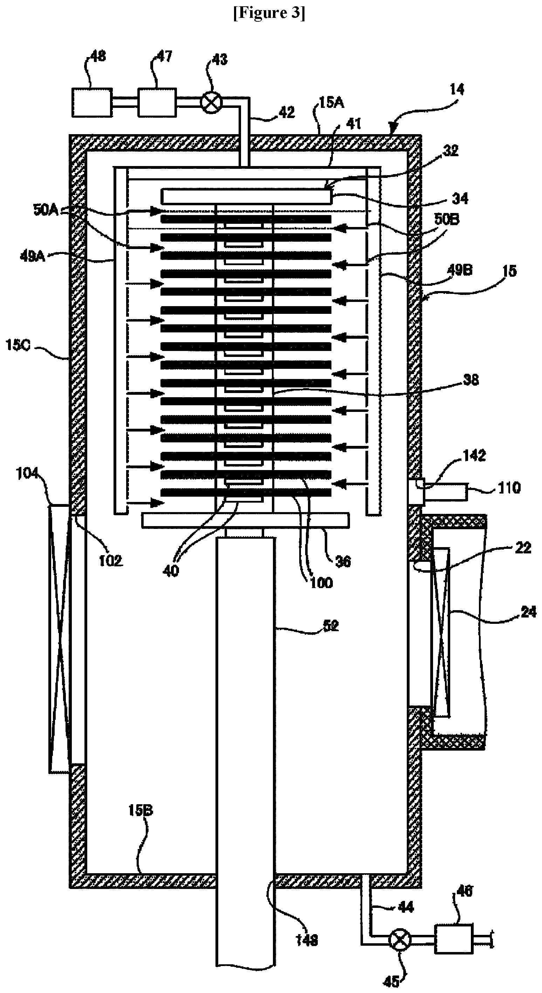

The load lock chamber 14 is constituted by a vessel (or a container) 15. For example, the vessel 15 is constituted by a top plate (top plate structure) 15A, a bottom plate (bottom plate structure) 15B, and an outer peripheral wall (outer peripheral wall structure) 15C. The boat 32 serving as a support (substrate support) is provided inside the vessel 15. The boat 32 is configured to support the wafers 100 in a multistage manner in the vertical direction. A driver (which is a driving structure or a driving apparatus) 150 is connected to the boat 32 through a shaft 52 serving as a support shaft capable of supporting the boat 32. The boat 32 is configured to be rotatable in the load lock chamber 14, and further configured to be elevated and lowered in the load lock chamber 14. As shown in FIG. 3, the driver 150 can elevate the boat 32 to a cooling position (which is located between nozzles 49A and 49B) where the wafers 100 loaded on the boat 32 are cooled. Each of the nozzles 49A and 49B is used as a cooling nozzle to cool the wafers 100 in the load lock chamber 14.

The boat 32 is configured by connecting an upper plate 34 and a lower plate 36 by a plurality of support columns 38. For example, a support structure 40 or a plurality of support structures (for example, from 1 support structure to 25 support structures) including the support structure 40 can be provided at each of the plurality of support columns 38. Hereinafter, the plurality of support structures including the support structure 40 may also be simply referred to as "support structures 40", and each of the support structures 40 may also be referred to as the "support structure 40". The support structure 40 is configured to be capable of supporting the wafer 100 substantially in a horizontal orientation. The support structures 40 are provided at each of the plurality of support columns 38 with a predetermined interval therebetween in the vertical direction. With the support structure 40 or the support structures 40, the boat 32 is configured to support one or more wafers (for example, from 1 wafer to 25 wafers) among the wafers 100 in a multistage manner with a predetermined interval therebetween, and further configured to support the one or more wafers substantially in the horizontal orientation.

For example, in the present specification, a notation of a numerical range such as "from 1 wafer to 25 wafers" means that a lower limit and an upper limit are included in the numerical range. Therefore, for example, the numerical range "from 1 wafer to 25 wafers" means a range equal to or more than 1 wafer and equal to or less than 25 wafers. The same also applies to other numerical ranges described herein.

The nozzles 49A and 49B are provided in the load lock chamber 14 to cool the wafers 100 accommodated in the load lock chamber 14. Each of the nozzles 49A and 49B is arranged along an inner surface of the vessel 15 in an arrangement direction of the wafers 100 accommodated in the boat 32, that is, in the vertical direction.

The nozzles 49A and 49B are provided with a plurality of gas supply holes 50A and a plurality of gas supply holes 50B, respectively. The gas supply holes 50A and the gas supply holes 50B are provided in a manner corresponding to the wafers 100, and configured such that an inert gas serving as a cooling gas can be supplied substantially in the horizontal direction with respect to a surface of each of the wafers 100. The gas supply holes 50A and the gas supply holes 50B are provided in the vertical direction and configured such that the inert gas can be ejected toward the surface (front surface) of each of the wafers 100 arranged as described above. The gas supply holes 50A and the gas supply holes 50B are provided at different positions for each of the nozzles 49A and 49B. Specifically, the gas supply holes 50A and the gas supply holes 50B are provided at different vertical heights in the nozzles 49A and 49B. Specifically, the gas supply holes 50A and the gas supply holes 50B are arranged alternately with respect to surfaces of the wafers 100 accommodated in the boat 32. In other words, for example, the gas supply holes 50A formed in the nozzle 49A are provided such that two adjacent wafers among the wafers 100 loaded on the boat 32 are provided between two adjacent gas supply holes among the gas supply holes 50A. Similarly, the gas supply holes 50B formed in the nozzle 49B are provided such that two adjacent wafers among the wafers 100 loaded on the boat 32 are provided between two adjacent gas supply holes among the gas supply holes 50B. Therefore, the inert gas is supplied to both surfaces (a front surface and a back surface) of the wafer 100 from different directions.

That is, the nozzle 49A is configured such that the inert gas is supplied to a first group (or a first wafer) among the wafers 100 supported by the boat 32, and the nozzle 49B is configured such that the inert gas is supplied to a second group (or a second wafer) among the wafers 100 different from the first group (or the first wafer). That is, the gas supply holes 50A are configured such that the inert gas is supplied toward the first group (or the first wafer) among the wafers 100, and the gas supply holes 50B are configured such that the inert gas is supplied toward the second group (or the second wafer) among the wafers 100 different from the first group (or the first wafer). In other words, the gas supply holes 50A of the nozzle 49A are configured such that the inert gas is supplied for the first group (or the first wafer) among the wafers 100, and the gas supply holes 50B of the nozzle 49B are configured such that the inert gas is supplied for the second group (or the second wafer) among the wafers 100 different from the first group (or the first wafer).

In addition, each of the nozzles 49A and 49B are located at a position spaced apart from the inner surface of the vessel 15 by a predetermined distance. In other words, a gap is provided between the inner surface of the vessel 15 and each of the nozzles 49A and 49B.

For example, by supplying a gas such as the inert gas, the nozzles 49A and 49B may be pushed in opposite directions with respect to the gas supply holes 50A and the gas supply holes 50B. Therefore, the nozzles 49A and 49B are configured to be located at positions spaced apart by a distance such that the nozzles 49A and 49B do not come into contact with the inner surface of the vessel 15 when the gas is supplied. Thereby, it is possible to suppress a generation of particles due to a contact between each of the nozzles 49A and 49B and the inner surface of the vessel 15 while exhausting the particles generated during supplying the gas. In addition, a cushioning material may be provided between the inner surface of the vessel 15 and each of the nozzles 49A and 49B. Thereby, it is possible to suppress the contact between each of the nozzles 49A and 49B and the inner surface of the vessel 15.

According to the present embodiments, configurations of the nozzles 49A and 49B are substantially the same except for the positions at which the gas supply holes 50A and the gas supply holes 50B are provided. Therefore, the nozzles 49A and 49B may also be collectively referred to as "nozzles 49". In addition, according to the present embodiments, the gas supply holes 50A and the gas supply holes 50B may also be collectively or individually referred to as "gas supply holes 50".

In a manner described above, it is possible to efficiently cool a back surface of an upper wafer (among the wafers 100) and a front surface of a lower wafer (among the wafers 100) located immediately below the upper wafer by supplying the gas (that is, the inert gas) through a single gas supply hole (among the gas supply holes 50) provided in a manner corresponding to a space between the upper wafer and the lower wafer. In addition, it is also possible to uniformly and efficiently cool the wafers 100 supported in the multistage manner. In other words, it is possible to improve a cooling efficiency of the wafers 100 in the vessel 15.

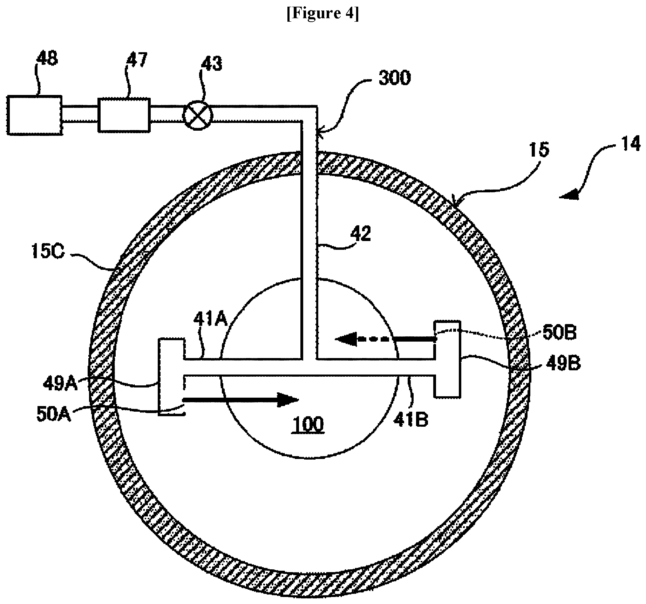

For example, as shown in FIG. 4, the nozzle 49A and the nozzle 49B are located (arranged) at different positions with respect to an inner circumferential surface of the vessel 15. Specifically, the nozzle 49A and the nozzle 49B are located at opposing positions around the wafer 100 when viewed from above the wafer 100. In other words, the nozzle 49A and the nozzle 49B are arranged along the inner circumferential surface of the vessel 15, between the inner circumferential surface of the vessel 15 and an edge of the wafer 100, so as to face each other with the wafer 100 interposed between the nozzles 49A and 49B.

In addition, the gas supply holes 50A of the nozzle 49A and the gas supply holes 50B of the nozzle 49B are configured to be positioned so as not to interfere with one another with respect to the wafer 100. In other words, the gas supply holes 50A of the nozzle 49A and the gas supply holes 50B of the nozzle 49B are configured to be provided at positions so as not to face one another.

In other words, the gas supply holes 50B of the nozzle 49B are not positioned on extension lines of the gas supply holes 50A of the nozzle 49A. In addition, the extension lines of the gas supply holes 50A of the nozzle 49A and extension lines of the gas supply holes 50B of the nozzle 49B are positioned substantially parallel to one another. The gas supply holes 50A of the nozzle 49A and the gas supply holes 50B of the nozzle 49B are located at positions spaced apart by a predetermined distance from one another and also spaced apart from a center of the wafer 100 when viewed from above the wafer 100, and are positioned so as to supply the inert gas toward the surface of the wafer 100 along different directions substantially parallel thereto. In other words, the nozzles 49A and 49B are located at the positions spaced apart from a center of the wafer 100 in the horizontal direction of the wafer 100.

Thereby, it is possible to avoid a collision of the inert gas on the wafer 100 between the nozzle 49A and the nozzle 49B, and it is also possible to prevent a disturbance of a flow of the inert gas on the surface of the wafer 100. As a result, it is possible to shorten a cooling time, and it is also possible to reduce an amount of the inert gas supplied into the load lock chamber 14. Thereby, it is possible to efficiently cool the wafers 100.

A gas supply pipe 42 is connected to the top plate 15A constituting the load lock chamber 14. The gas supply pipe 42 communicates with the nozzles 49A and 49B through gas supply pipes 41A and 41B, respectively. An inert gas supply source 48, a mass flow controller (MFC) 47 serving as a flow rate controller (flow rate control structure) and a valve 43 serving as an opening and closing valve are sequentially provided at the gas supply pipe 42 in this order from an upstream side toward a downstream side of the gas supply pipe 42 in a gas flow direction. An inert gas supply system (inert gas supplier) 300 configured to supply the inert gas to the wafers 100 is constituted mainly by the gas supply pipe 42, the MFC 47 and the valve 43. The inert gas supply system 300 may also be referred to as a "cooling gas supply system" which is a cooling gas supplier. The inert gas supply system 300 may further include at least one among the gas supply pipes 41A and 41B, the inert gas supply source 48 and the nozzles 49A and 49B. The inert gas supply system 300 is provided on a top (upper portion) of the vessel 15. Thereby, it is possible to efficiently supply the inert gas into the vessel 15. A cooling system capable of cooling the wafers 100 in the load lock chamber 14 is constituted by the vessel 15 and the inert gas supply system 300.

That is, the inert gas supply system 300 provided at a center of the top of the vessel 15 is configured such that the inert gas can be distributed via the gas supply pipes 41A and 41B to the nozzles 49A and 49B arranged along an inner circumference of the vessel 15, and can be supplied to the wafers 100 in the vessel 15. Thereby, it is possible to efficiently supply the inert gas into the vessel 15. In addition, by distributing and supplying the inert gas through the gas supply pipe 42 to the nozzle 49 (that is, the nozzles 49A and 49B), it is possible to simplify a piping configuration, and it is also possible to improve a maintainability (maintenance efficiency) by reducing the number of components related thereto.

According to the present embodiments, configurations of the gas supply pipes 41A and 41B are substantially the same except for the positions at which the gas supply pipes 41A and 41B are provided. Therefore, the gas supply pipes 41A and 41B may also be collectively or individually referred to as a "gas supply pipe 41".

The inert gas supplied through the gas supply pipe 42 is supplied into the load lock chamber 14 through the gas supply holes 50A of the nozzle 49A and the gas supply holes 50B of the nozzle 49B.

As the inert gas, for example, a gas such as nitrogen (N₂) gas and a rare gas may be used.

An exhaust pipe 44 communicating with an inside of the load lock chamber 14 is connected to the bottom plate 15B constituting the load lock chamber 14. A valve 45 and a vacuum pump 46 serving as a vacuum exhaust apparatus are sequentially provided at the exhaust pipe 44 in this order from an upstream side toward a downstream side of the exhaust pipe 44 in the gas flow direction. An exhaust system (exhauster) is constituted mainly by the exhaust pipe 44 and the valve 45. The exhaust system may further include the vacuum pump 46. The exhaust system is provided at a bottom (lower portion) of the vessel 15. By providing the exhaust system at the bottom of the vessel 15, it is possible to efficiently exhaust a substance such as the inert gas and the particles in the vessel 15.

An opening 102 is provided on the outer peripheral wall 15C constituting the load lock chamber 14. The wafer 100 can be loaded into or unloaded from the load lock chamber 14 through the opening 102. Specifically, the opening 102 is provided on the outer peripheral wall 15C so as to face the atmospheric robot 30. The atmospheric robot 30 is configured to transfer the wafer 100 to the boat 32 through the opening 102 such that the wafer 100 is supported by the boat 32 and to transfer (take out) the wafer 100 from the boat 32 through the opening 102.

In addition, a gate valve 104 capable of opening and closing the opening 102 is provided on the outer peripheral wall 15C.

According to the present embodiments, the valve 43 is closed while the communication structure 22 and the opening 102 are closed by the gate valves 24 and 104, respectively. In such a state, when the valve 45 is opened and the vacuum pump 46 is operated, an inner atmosphere of the load lock chamber 14 is vacuum exhausted such that the inner pressure of the load lock chamber 14 can be set (adjusted) to the vacuum pressure (or a decompressed state). In addition, in a state in which the communication structure 22 and the opening 102 are closed by the gate valves 24 and 104, respectively, when the valve 45 is closed (or an opening degree of the valve 45 is reduced) and the valve 43 is opened to supply the inert gas into the load lock chamber 14, the inner pressure of the load lock chamber 14 can be set to the atmospheric pressure.

In addition, a window (window structure) 142 is provided in the outer peripheral wall 15C at a position corresponding to the wafer 100 that is last loaded into the load lock chamber 14 (that is, a lowermost wafer supported at a lowermost portion (bottom) of the boat 32) when the wafers 100 loaded on the boat 32 are placed in cooling positions. For example, the window 142 is made of a material through which a light can pass. A temperature sensor 110 is provided on an outer side of the window 142.

The temperature sensor 110 is configured to measure a temperature (inner temperature) of the vessel 15 or a temperature of the wafer 100 supported at the lowermost portion of the boat 32, that is, the temperature of the wafer 100 (that is, the processed wafer 100) last loaded into the vessel 15. In other words, the temperature sensor 110 can measure the inner temperature of the vessel 15 or the temperature of the wafer 100 from outside the vessel 15. In addition, by measuring the temperature of the wafer 100 that is last loaded into the vessel 15, it is possible to estimate that temperatures of the entire wafers 100 in the vessel 15 are equal to or lower than the temperature of the wafer 100 whose temperature is measured by the temperature sensor 110.

According to the present embodiments, for example, the temperature sensor 110 is provided at the position of the wafer 100 supported at the lowermost portion of the boat 32. However, the temperature sensor 110 may be provided at a position where the temperature of the wafer 100 that is last loaded into the vessel 15 can be measured. Therefore, the temperature sensor 110 may not be provided at the lowermost portion of the boat 32 and may be provided another position of the boat 32.

As shown in FIGS. 2 and 3, an opening 148 communicating between the inside and outside of the load lock chamber 14 is provided at the bottom plate 15B. The driver (which is the driving structure) 150 capable of elevating and lowering the boat 32 and rotating the boat 32 through the opening 148 is provided below the load lock chamber 14.

The driver 150 may include: the shaft 52; a bellows (which is extendable and retractable, not shown) provided so as to surround the shaft 52; a fixing base 56 to which lower ends of the shaft 52 and the bellows are fixed; an elevation driver (which is an elevation driving structure or an elevator) 58 capable of elevating and lowering the boat 32 via the shaft 52; a connection structure 60 capable of connecting the elevation driver 58 and the fixing base 56; and a rotation driver (which is a rotation driving structure) 62 capable of rotating the boat 32.

The elevation driver 58 is configured to be capable of elevating and lowering the boat 32, that is, the wafers 100 in the boat 32.

The rotation driver 62 is configured to be capable of rotating the boat 32, that is, the wafers 100 in the boat 32. Specifically, the rotation driver 62 rotates the boat 32 around the shaft 52 serving as a rotation axis.

### (2) Configuration of Controller

Subsequently, a configuration of a controller 120 serving as a control structure (control apparatus) will be described. The controller 120 is configured to control components mentioned above so as to perform a substrate processing described later.

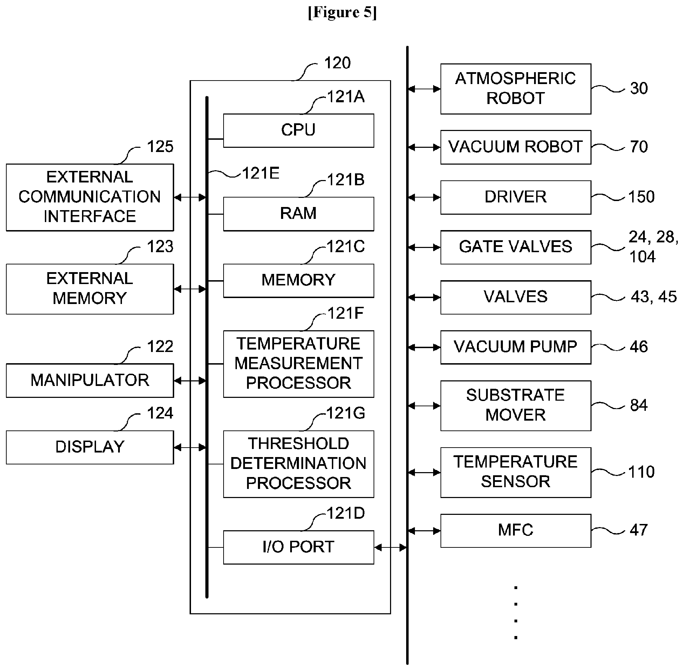

As shown in FIG. 5, the controller 120 is constituted by a computer including a CPU (Central Processing Unit) 121A, a RAM (Random Access Memory) 121B, a memory 121C, an I/O port (input/output port) 121D, a temperature measurement processor 121F and a threshold determination processor 121G. The controller 120 is configured to be capable of controlling a processing of the wafer 100.

The RAM 121B, the memory 121C, the I/O port 121D, the temperature measurement processor 121F and the threshold determination processor 121G are configured to exchange data with the CPU 121A through an internal bus 121E. For example, a manipulator 122 may be connected to the controller 120. A display (which is a display structure) 124 is connected to the manipulator 122 through the internal bus 121E. The display 124 is configured to be capable of displaying a state of the wafer 100 such that state of the wafer 100 can be checked. For example, the manipulator 122 may be constituted by a component such as a touch panel. In such a case, the manipulator 122 and the display 124 may be provided in the same housing. In addition, an external communication interface 125 for communicating with an external apparatus may be connected to the controller 120.

For example, the memory 121C is configured by a component such as a flash memory and a hard disk drive (HDD). For example, a control program configured to control operations of the substrate processing apparatus 10 or a process recipe containing information on procedures and conditions of the substrate processing described later may be readably stored in the memory 121C. The process recipe is obtained by combining steps (procedures) of the substrate processing described later such that the controller 120 can execute the steps by using the substrate processing apparatus 10 to acquire a predetermined result, and functions as a program. Hereinafter, the process recipe and the control program may be collectively or individually referred to as a "program". Further, the process recipe may also be simply referred to as a "recipe". Thus, in the present specification, the term "program" may refer to the recipe alone, may refer to the control program alone, or may refer to both of the recipe and the control program. The RAM 121B functions as a memory area (work area) where a program or data read by the CPU 121A is temporarily stored.

The I/O port 121D is connected to components mentioned above such as the atmospheric robot 30, the vacuum robot 70, the driver 150, the gate valve 24, the gate valve 28, the gate valve 104, the valve 43, the valve 45, the vacuum pump 46, the substrate mover 84, the temperature sensor 110, the MFC 47, the first heater (not shown) and the second heater (not shown).

The CPU 121A is configured to read and execute the control program stored in the memory 121C, and to read the recipe stored in the memory 121C in accordance with an instruction such as an operation command inputted via the manipulator 122. For example, in accordance with contents of the recipe read from the memory 121C, the CPU 121A is configured to be capable of controlling various operations such as transfer operations for the wafer 100 by the atmospheric robot 30, the vacuum robot 70, the driver 150 and the substrate mover 84, opening and closing operations of the gate valves 24, 28 and 104, opening and closing operations of the valves 43 and 45, a flow rate adjusting operation and a pressure adjusting operation by the MFC 47 and the vacuum pump 46, and a temperature adjusting operation by the first heater and the second heater.

The controller 120 may be embodied by installing the above-mentioned program stored in an external memory 123 into the computer. For example, the external memory 123 may be constituted by a component such as a magnetic disk such as a hard disk, an optical disk such as a CD, a magneto-optical disk such as an MO and a semiconductor memory such as a USB memory. The memory 121C and the external memory 123 may be embodied by a non-transitory computer readable recording medium. Hereafter, the memory 121C and the external memory 123 may be collectively or individually referred to as a "recording medium". Thus, in the present specification, the term "recording medium" may refer to the memory 121C alone, may refer to the external memory 123 alone, or may refer to both of the memory 121C and the external memory 123. Instead of the external memory 123, a communication interface such as the Internet and a dedicated line may be used for providing the program to the computer.

By using the temperature sensor 110, the temperature measurement processor 121F of the controller 120 measures the inner temperature of the vessel 15 or the temperature of the wafer 100 supported at the lowermost portion of the boat 32, that is, the temperature of the wafer 100 last loaded into the vessel 15.

In addition, the controller 120 is configured to be capable of controlling an elevating and lowering operation and a rotating operation of the boat 32 by the driver 150. The controller 120 is configured to be capable of controlling the boat 32 to be elevated or lowered after loading the wafer 100 into the vessel 15 and to wait (or stand by) until loading a subsequent wafer 100.

In addition, the controller 120 is configured to start a supply of the inert gas before or at a start of loading the wafer 100 into the vessel 15. Further, the controller 120 is configured to continue the supply of the inert gas while the wafer 100 is being loaded into the vessel 15.

For example, based on the temperature measured by the temperature measurement processor 121F, the threshold determination processor 121G of the controller 120 is configured to determine whether the inner temperature of the vessel 15 or the temperature of the wafer 100 supported at the lowermost portion of the boat 32 (that is, the temperature of the wafer 100 last loaded into the vessel 15) is equal to or lower than a threshold value. Then, when the threshold determination processor 121G of the controller 120 determines that the inner temperature of the vessel 15 or the temperature of the wafer 100 supported at the lowermost portion of the boat 32 (that is, the temperature of the wafer 100 last loaded into the vessel 15) is equal to or lower than the threshold value, the controller 120 is configured to close the valve 43 to stop the supply of the inert gas into the vessel 15.

That is, the controller 120 is configured to be capable of controlling a flow rate of the inert gas supplied into the vessel 15 by controlling components such as the MFC 47 and the valve 43, based on the temperature measured by the temperature measurement processor 121F. In addition, when the threshold determination processor 121G of the controller 120 determines that the inner temperature of the vessel 15 (which is measured by the temperature measurement processor 121F) or the temperature of the wafer 100 (which is measured by the temperature measurement processor 121F) supported at the lowermost portion of the boat 32 (that is, the temperature of the wafer 100 last loaded into the vessel 15) is equal to or lower than the threshold value (which is set in advance), the controller 120 is configured to close the valve 43 to stop the supply of the inert gas into the vessel 15. In a manner described above, by adjusting the flow rate of the inert gas, it is possible to adjust an effect of the inert gas on the wafer 100. In addition, as a result, it is possible to shorten a cooling time of the wafer 100, and it is possible to reduce the amount of the inert gas supplied into the load lock chamber 14. It is also possible to efficiently cool the wafers 100. In other words, by controlling the temperature of the wafer 100 last loaded into the vessel 15 to be equal to or lower than the threshold value, it is possible to set the temperatures of the entire wafers 100 in the vessel 15 to be equal to or lower than the threshold value before the wafers 100 are transferred from the load lock chamber 14 to the pods 27-1 to 27-3. Thereby, it is possible to suppress a thermal effect on the atmospheric robot 30 or the pods 27-1 to 27-3.

### (3) Substrate Processing

Subsequently, as a part of a manufacturing process of a semiconductor device, a method of manufacturing the semiconductor device by using the substrate processing apparatus 10 mentioned above (that is, process sequences of the substrate processing of processing the wafer 100) will be described with reference to FIGS. 1, 2 and 6. In addition, in the following description, operations of components constituting the substrate processing apparatus 10 are controlled by the controller 120.

First, the wafers 100 stored in the pods 27-1 to 27-3 are transferred into the atmospheric transfer chamber 12 by the atmospheric robot 30. When transferring the wafers 100 into the atmospheric transfer chamber 12, the gate valve 104 is in a closed state.

Subsequently, after setting (adjusting) the inner pressure of the load lock chamber 14 to the atmospheric pressure, the gate valve 104 is opened. Specifically, the valve 43 of the gas supply pipe 42 is opened to supply the inert gas into the load lock chamber 14. After setting the inner pressure of the load lock chamber 14 to the atmospheric pressure in a manner described above, the gate valve 104 is opened. When setting the inner pressure of the load lock chamber 14 to the atmospheric pressure, the gate valve 24 is in a closed state.

Subsequently, the wafer 100 is transferred (loaded) into the load lock chamber 14. Specifically, the wafer 100 loaded into the atmospheric transfer chamber 12 is transferred into the load lock chamber 14 by the atmospheric robot 30, and is placed on the boat 32 in the load lock chamber 14.

Subsequently, after the gate valve 104 is closed, the inner pressure of the load lock chamber 14 is set to the vacuum pressure. Specifically, after a predetermined number of the wafers 100 are supported by the boat 32, the valve 45 of the exhaust pipe 44 is opened so as to exhaust the inside of the load lock chamber 14 by the vacuum pump 46. Thereby, it is possible to set the inner pressure of the load lock chamber 14 to the vacuum pressure. In addition, when setting the inner pressure of the load lock chamber 14 to the vacuum pressure, an inner pressure of the transfer chamber 16 and an inner pressure of the process chamber 18 are also set to the vacuum pressure.

Subsequently, the wafer 100 is transferred from the load lock chamber 14 to the process chamber 18. Specifically, first, the gate valve 24 is opened. When opening the gate valve 24, the elevation driver 58 can elevate or lower the boat 32 such that the wafer 100 supported by the boat 32 is capable of being transferred (or taken out) by the vacuum robot 70. In addition, the rotation driver 62 can rotate the boat 32 such that a substrate loading/unloading port of the boat 32 faces the transfer chamber 16.

The vacuum robot 70 extends the finger 78 of the arm structure 76 toward the boat 32 and places the wafer 100 on the finger 78. After retracting the finger 78, the vacuum robot 70 rotates the arm structure 76 such that the arm structure 76 faces the process chamber 18. Subsequently, the vacuum robot 70 extends the finger 78 such that the wafer 100 is loaded into the process chamber 18 through the communication structure 26 with the gate valve 28 opened.

In the process chamber 18, the wafer 100 placed on the finger 78 may be placed on the first mounting table 96 of the first process structure 80, or may be transferred to the mover 86 standing by on a side portion of the first process structure 80. After receiving the wafer 100, the mover 86 is rotated toward the second process structure 82 and places the wafer 100 on the second mounting table 92.

Then, in the process chamber 18, the wafer 100 is subjected to a predetermined process such as an ashing process. In the predetermined process, the temperature of the wafer 100 is elevated by being heated by the heater such as the first heater and the second heater, or by being heated by a reaction heat generated by performing the predetermined process.

Subsequently, the wafer 100 after the predetermined process is performed (that is, the processed wafer 100) is transferred (or loaded) from the process chamber 18 to the load lock chamber 14. A transfer of the wafer 100 from the process chamber 18 to the load lock chamber 14 is performed in an order reverse to that of loading the wafer 100 into the process chamber 18.

First, in a step S101, the controller 120 controls the boat 32 to wait (stand by) in the load lock chamber 14 at an initial loading position (initial position) for the wafers 100. That is, the controller 120 sets the boat 32 at the initial loading position. For example, the initial loading position for the wafers 100 is a position where the wafer 100 is loaded (transferred) onto, for example, an uppermost support structure among the support structures 40 of the boat 32.

Subsequently, in a step S102, the controller 120 starts the supply of the inert gas serving as the cooling gas. That is, the controller 120 starts the supply of the inert gas before or at a start of loading the initial wafers 100 into the load lock chamber 14. Then, the controller 120 continues the supply of the inert gas while the wafers 100 are being loaded. When loading the wafers 100, the inner pressure of the load lock chamber 14 is maintained at the vacuum pressure. In a manner described above, by supplying the inert gas serving as the cooling gas before or at the start of loading the wafers 100 (that is, the processed wafers 100), it is possible to suppress a temperature rise (temperature elevation) in the vessel 15, and it is also possible to improve the cooling efficiency of the wafers 100.

Subsequently, in a step S103, the controller 120 transfers the processed wafers 100 from the process chamber 18 into the boat 32 in the load lock chamber 14.

Subsequently, in a step S104, the controller 120 elevates or lowers the boat 32. That is, after loading the wafer 100 into the load lock chamber 14, the controller 120 elevates or lowers the boat 32 and waits (stands by) until the loading of the subsequent wafer 100. Thereby, it is possible to improve a loading efficiency of the wafers 100.

Subsequently, in a step S105, the controller 120 determines whether or not the wafer 100 being loaded into the boat 32 is the last wafer among the wafers 100. When the controller 120 determines that the wafer 100 being loaded into the boat 32 is the last wafer, a subsequent step S106 is performed. On the other hand, when the controller 120 determines that the wafer 100 being loaded into the boat 32 is not the last wafer, the step S103 is performed again.

Subsequently, in the step S106, when the wafer 100 being loaded into the boat 32 is the last wafer and the wafers 100 (that is, the processed wafers 100) are completely loaded into the boat 32, the controller 120 closes the gate valve 24, elevates the boat 32 to the cooling position, and sets the inner pressure of the load lock chamber 14 to the atmospheric pressure. In addition, according to the present embodiments, for example, by elevating the boat 32 to the highest position in the load lock chamber 14 and supplying the inert gas in such a state to cool the boat 32, it is possible to promote the cooling of the wafers 100 by the cooling system. In other words, the boat 32 and the processed wafers 100 supported by the boat 32 are cooled by the inert gas supplied into the load lock chamber 14. When cooling the processed wafers 100 by the inert gas, by using the temperature sensor 110, the temperature measurement processor 121F of the controller 120 measures the temperature of the wafer 100 last loaded into the boat 32.

Subsequently, in a step S107, based on the temperature measured by the temperature measurement processor 121F, the threshold determination processor 121G of the controller 120 determines whether the inner temperature of the vessel 15 or the temperature of the wafer 100 supported at the lowermost portion of the boat 32 (that is, the temperature of the wafer 100 last loaded into the vessel 15) is equal to or lower than the threshold value. Then, when the threshold determination processor 121G of the controller 120 determines that the inner temperature of the vessel 15 or the temperature of the wafer 100 supported at the lowermost portion of the boat 32 (that is, the temperature of the wafer 100 last loaded into the vessel 15) is equal to or lower than the threshold value, a subsequent step S108 is performed. On the other hand, when the threshold determination processor 121G of the controller 120 determines that the inner temperature of the vessel 15 or the temperature of the wafer 100 supported at the lowermost portion of the boat 32 (that is, the temperature of the wafer 100 last loaded into the vessel 15) is higher than the threshold value, the step S106 is performed again.

Subsequently, in the step S108, when it is determined, by the threshold determination processor 121G of the controller 120, that the inner temperature of the vessel 15 or the temperature of the wafer 100 supported at the lowermost portion of the boat 32 (that is, the temperature of the wafer 100 last loaded into the vessel 15) is equal to or lower than the threshold value, the controller 120 closes the valve 43 to stop the supply of the inert gas into the vessel 15.

Subsequently, the wafer 100 (which is cooled in a manner described above) is unloaded from the load lock chamber 14 to an atmospheric pressure region (for example, the atmospheric transfer chamber 12). Specifically, the wafer 100 is transferred from the load lock chamber 14 with the gate valve 104 open to the atmospheric transfer chamber 12 by using the atmospheric robot 30. Thereby, the transfer operation of the wafer 100 is completed. In addition, by transferring the wafer 100 (which is cooled) to the atmospheric transfer chamber 12, a process of manufacturing the semiconductor device (that is, the wafer 100) is completed.

### <Other Embodiments of Present Disclosure>

The technique of the present disclosure is described in detail by way of the embodiments mentioned above. However, the technique of the present disclosure is not limited thereto. The technique of the present disclosure may be modified in various ways without departing from the scope thereof.

For example, the embodiments mentioned above are described by way of an example in which the load lock chamber 14 is used as the vessel 15 to cool the wafers 100 (that is, the processed wafers 100). However, the technique of the present disclosure is not limited thereto. For example, the technique of the present disclosure may be preferably applied when the process chamber 18 is used as the vessel 15 to cool the wafers 100 (that is, the processed wafers 100). Even in such a case, it is possible to obtain substantially the same effects as in the embodiments mentioned above.

For example, the embodiments mentioned above are described by way of an example in which the cooling system is provided separately from the boat 32 supporting (holding) the wafers 100. However, the technique of the present disclosure is not limited thereto. For example, the boat 32 may be used as the cooling system. When the boat 32 is used as the cooling system, a supply path for supplying the inert gas is provided to the plurality of support columns 38 of the boat 32, and the support structures 40 supporting the wafers 100 are provided with the gas supply holes 50 that communicate with the supply path such that the inert gas can be supplied to different wafers 100 in a manner similar to that mentioned above. In other words, according to such a modified example, the gas supply holes 50 are provided at different positions respectively for the plurality of support columns 38. Even in such a modified example, it is possible to obtain substantially the same effects as in the embodiments mentioned above. **In** addition, according to such a modified example, it is possible to cool the wafers 100 supported by the boat 32 regardless of a stopping position of the boat 32.

For example, the embodiments mentioned above are described by way of an example in which the two nozzles (that is, the nozzles 49A and 49B serving as the nozzles 49) are arranged along the inner circumferential surface of the vessel 15. However, the technique of the present disclosure is not limited thereto. For example, three or more nozzles serving as the nozzles 49 may be arranged along the inner circumferential surface of the vessel 15. **In** such a modified example, the three or more nozzles are configured to be positioned so as not to interfere with one another. For example, when three nozzles serving as the nozzles 49 are arranged in the vessel 15, the gas supply holes 50 provided in each of the three nozzles are formed such that three adjacent wafers among the wafers 100 loaded on the boat 32 are placed between adjacent gas supply holes among the gas supply holes 50. In other words, the intervals between the gas supply holes 50 vary according to the number of the nozzles serving as the nozzles 49. Even in such a modified example, it is possible to obtain substantially the same effects as in the embodiments mentioned above. In addition, in such a modified example, it is possible to efficiently cool the wafers 100 by supplying the inert gas in a plurality of directions. In addition, by arranging a plurality of nozzles serving as the nozzles 49 at positions where the plurality of nozzles do not interfere with one another, it is possible to avoid a collision of the inert gas on the wafers 100.

For example, the embodiments mentioned above are described by way of an example in which the gas supply holes 50 are provided in each of the two nozzles (that is, the nozzles 49A and 49B serving as the nozzles 49) in the vertical direction. However, the technique of the present disclosure is not limited thereto. For example, the technique of the present disclosure may be preferably applied when a gas supply hole alone instead of the gas supply holes 50 is provided in each of a plurality of nozzles serving as the nozzles 49. Even in such a modified example, it is possible to obtain substantially the same effects as in the embodiments mentioned above.

That is, configurations (such as the number and arrangement of the nozzles) described in the embodiments mentioned above are merely an example, and the configurations described in the embodiments mentioned above may be changed according to circumstances without departing from the scope of the technique of the present disclosure.

In addition, a process flow described in the embodiments mentioned above is merely an example, and redundant steps may be deleted, new steps may be added or process procedures may be changed without departing from the scope of the technique of the present disclosure.

For example, it is preferable that recipes used in processes are prepared individually in accordance with contents of the processes and stored in the memory 121C via an electric communication line or the external memory 123. When starting each process, it is preferable that the CPU 121A selects an appropriate recipe among the recipes stored in the memory 121C in accordance with the contents of each process. Thus, various films of different composition ratios, qualities and thicknesses can be formed in a reliably reproducible manner by using a single substrate processing apparatus (that is, the substrate processing apparatus described above). In addition, since a burden on an operating personnel can be reduced, various processes can be performed quickly while avoiding an error in operating the substrate processing apparatus.

The recipe described above is not limited to creating a new recipe. For example, the recipe may be prepared by changing an existing recipe stored (or installed) in the substrate processing apparatus in advance. When changing the existing recipe to a new recipe, the new recipe may be installed in the substrate processing apparatus via the electric communication line or a recording medium in which the new recipe is stored. Further, the existing recipe already stored in the substrate processing apparatus may be directly changed to the new recipe by operating the manipulator 122 of the substrate processing apparatus.

The present invention may be summarized as follows: It is possible to improve a cooling efficiency of a substrate. There is provided a technique that includes: a vessel provided with a support capable of supporting a plurality of substrates in a multistage manner; and a plurality of cooling nozzles arranged along an inner surface of the vessel, wherein each of the plurality of cooling nozzles is provided with a gas supply hole through which a cooling gas is supplied for the plurality of substrates supported by the support, wherein a first cooling nozzle and a second cooling nozzle among the plurality of cooling nozzles are configured such that the cooling gas is supplied for a first substrate among the plurality of substrates through the gas supply hole of the first cooling nozzle, and the cooling gas is supplied for a second substrate other than the first substrate among the plurality of substrates through the gas supply hole of the second cooling nozzle.

For example, the embodiments mentioned above are described by way of an example in which a single wafer type substrate processing apparatus capable of simultaneously processing one or several substrates is used. However, the technique of the present disclosure is not limited thereto. For example, the technique of the present disclosure may be preferably applied when a batch type substrate processing apparatus capable of simultaneously processing a plurality of wafers 100 is used. For example, the embodiments mentioned above are described by way of an example in which a substrate processing apparatus including a cold wall type process furnace is used. However, the technique of the present disclosure is not limited thereto. For example, the technique of the present disclosure may be preferably applied when a substrate processing apparatus including a hot wall type process furnace is used.

The process procedures and the process conditions of each process using the substrate processing apparatuses mentioned above may be substantially the same as those of the embodiments mentioned above. Even in such a case, it is possible to obtain substantially the same effects as in the embodiments mentioned above.

Further, the embodiments and the modified examples mentioned above may be appropriately combined. The process procedures and the process conditions of each combination thereof may be substantially the same as those of the embodiments mentioned above.

### [Description of Reference Numerals]

| | | | |
|---|---|---|---|
| 15 | Vessel | 32 | Boat (support) |
| 49A, 49B | Nozzle (cooling nozzle) | 50A, 50B | Gas supply holes |
| 100 | Wafer (substrate) | | |

## Claims

1. A cooling system comprising:
a vessel provided with a support capable of supporting a plurality of substrates in a multistage manner; and
a plurality of cooling nozzles arranged along an inner surface of the vessel, wherein each of the plurality of cooling nozzles is provided with a gas supply hole through which a cooling gas is supplied for the plurality of substrates supported by the support,
wherein a first cooling nozzle and a second cooling nozzle among the plurality of cooling nozzles are configured such that the cooling gas is supplied for a first substrate among the plurality of substrates through the gas supply hole of the first cooling nozzle, and the cooling gas is supplied for a second substrate other than the first substrate among the plurality of substrates through the gas supply hole of the second cooling nozzle.

2. The cooling system of claim 1, wherein at least one of the plurality of cooling nozzles is located at a position spaced apart from the inner surface of the vessel.

3. The cooling system of claim 1 and/or 2, wherein the plurality of cooling nozzles are located along an inner peripheral surface of the vessel in a manner that the plurality of cooling nozzles face one another.

4. The cooling system of any one or more of claims 1 to 3, wherein each of the plurality of cooling nozzles is provided with a plurality of gas supply holes comprising the gas supply hole.

5. The cooling system of claim 4, wherein locations of the plurality of gas supply holes are different between the plurality of cooling nozzles.

6. The cooling system of claim 4 and/or 5, wherein intervals of the plurality of gas supply holes are set such that the intervals vary in accordance with the number of the plurality of cooling nozzles.

7. The cooling system of any one or more of claims 1 to 6, further comprising
a cooling gas supplier configured to supply the cooling gas,
wherein the cooling gas supplier is provided on an upper portion of the vessel.

8. The cooling system of claim 7, wherein the cooling gas is supplied through the cooling gas supplier and is distributed to the plurality of cooling nozzles.

9. The cooling system of any one or more of claims 1 to 8, further comprising:
a temperature sensor configured to measure an inner temperature of the vessel; and a controller configured to be capable of controlling a processing of the plurality of substrates,
wherein the controller is further configured to be capable of controlling a flow rate of the cooling gas based on the temperature measured by the temperature sensor.

10. The cooling system of any one or more of claims 1 to 9, wherein the gas supply hole of the first cooling nozzle and the gas supply hole of the second cooling nozzle are located at positions so as not to face each other.

11. The cooling system of any one or more of claims 1 to 10, wherein the plurality of cooling nozzles are located at positions spaced apart from a center of each of the plurality of substrates in a horizontal direction of each of the plurality of substrates.

12. A substrate processing apparatus comprising:
a cooling system comprising:
a vessel provided with a support capable of supporting a plurality of substrates in a multistage manner; and
a plurality of cooling nozzles arranged along an inner surface of the vessel, wherein each of the plurality of cooling nozzles is provided with a gas supply hole through which a cooling gas is supplied for the plurality of substrates supported by the support,
wherein a first cooling nozzle and a second cooling nozzle among the plurality of cooling nozzles are configured such that the cooling gas is supplied for a first substrate among the plurality of substrates through the gas supply hole of the first cooling nozzle, and the cooling gas is supplied for a second substrate other than the first substrate among the plurality of substrates through the gas supply hole of the second cooling nozzle; and
a controller configured to be capable of controlling the plurality of substrates to be cooled after being heated by being processed.

13. A substrate processing method comprising:
(a) processing a plurality of substrates;
(b) loading the plurality of substrates into a vessel provided with a support capable of supporting the plurality of substrates in a multistage manner; and
(c) cooling the plurality of substrates by supplying a cooling gas through a plurality of cooling nozzles arranged along an inner surface of the vessel, wherein each of the plurality of cooling nozzles is provided with a gas supply hole through which the cooling gas is supplied for the plurality of substrates supported by the support,
wherein, the plurality of cooling nozzles comprise a first cooling nozzle and a second cooling nozzle, and
wherein, in (c), the cooling gas is supplied for a first substrate among the plurality of substrates through the gas supply hole of the first cooling nozzle, and the cooling gas is supplied for a second substrate other than the first substrate among the plurality of substrates through the gas supply hole of the second cooling nozzle.

14. A method of manufacturing a semiconductor device, comprising the method of claim 13.

15. A program that causes a substrate processing apparatus, by a computer, to perform:
(a) processing a plurality of substrates;
(b) loading the plurality of substrates into a vessel provided with a support capable of supporting the plurality of substrates in a multistage manner; and
(c) cooling the plurality of substrates by supplying a cooling gas through a plurality of cooling nozzles arranged along an inner surface of the vessel, wherein each of the plurality of cooling nozzles is provided with a gas supply hole through which the cooling gas is supplied for the plurality of substrates supported by the support,
wherein, the plurality of cooling nozzles comprise a first cooling nozzle and a second cooling nozzle, and
wherein, in (c), the cooling gas is supplied for a first substrate among the plurality of substrates through the gas supply hole of the first cooling nozzle, and the cooling gas is supplied for a second substrate other than the first substrate among the plurality of substrates through the gas supply hole of the second cooling nozzle.
